# EUROPÄISCHE PATENTSCHRIFT

(11) **EP 1 326 338 B1**
(45) Veröffentlichungstag und Bekanntmachung des Hinweises auf die Patenterteilung: **17.06.2009**
(21) Anmeldenummer: 02027101.1
(22) Anmeldetag: 04.12.2002
(51) Int. Cl.: H03K 17/16

(54) **Vorrichtung zur Ansteuerung eines elektrischen Leistungsbauelements**
Device for controlling an electric power component
Dispositif servant à commander un composant électrique de puissance

(30) Priorität: 29.12.2001 DE 10164486
(43) Veröffentlichungstag der Anmeldung: 09.07.2003
(73) Patentinhaber: ROBERT BOSCH GMBH, 70442 Stuttgart (DE)
(72) Erfinder: Lohmueller, Horst, 72144 Dusslingen (DE); Mager, Thomas, 72793 Pfullingen (DE)

(56) Entgegenhaltungen:
- EP-A- 0 963 044
- US-A- 5 194 760
- US-A- 5 939 909
- US-A- 5 949 249
- US-A- 6 088 206
- US-A- 6 137 329

## Beschreibung

### Stand der Technik

Zunehmend kommen in der Schaltungstechnik, insbesondere im Automobilbereich, mehr getaktete Systeme zum Einsatz, wobei diese Entwicklung insbesondere bei den hochintegrierten Schaltungen besonders stark zu beobachten ist. Allgemein bekannt sind solche getakteten Systeme, wobei zur Ansteuerung von Leistungsbauelementen feste schaltbare Ströme oder Spannungen bzw. Rampen bereitgestellt werden. In solchen getakteten Systeme wird - insbesondere bedingt durch die zum Teil großen, zu schaltenden Energien oder Ströme - zunehmend eine größere elektromagnetische Strahlung abgestrahlt, die zu Problemen bei der elektromagnetischen Verträglichkeit (EMV) mit anderen Systemen führt. Insbesondere im Kabelbaum bzw. im Bordnetz von Fahrzeugen kommt es durch die bekannten getakteten Systeme zu einer Störung anderer Komponenten. Besonders ist hier die Störung des Rundfunkempfangs hervorzuheben.

Aus der EP-A-0 963 044 ist eine Schaltung zur Ansteuerung eines elektrischen Leistungsbauelements bekannt, bei der ein Schaltvorgang am Leistungsbauelement sowohl mittels einer Spannungssteuerung oder mittels einer Spannungsregelung erfolgen kann. Das Leistungsbauelement weist einen Schaltausgang auf, dessen Pegel dem Schaltzustand entspricht. Über Konstantstromquellen, die mit dem Eingang des Leistungsbauelements in Verbindung stehen, kann ebenfalls ein Schaltvorgang ausgelöst werden.

Aus der US-A-6 137 329 ist eine Schaltung zur Ansteuerung eines elektrischen Leistungsbauelements bekannt, bei der das Gate des Leistungsbauelements mit Stromspiegeln in Verbindung steht.

Aus der US-A-5 194 760 sind weitere Vorrichtungen zur Ansteuerung eines elektrischen Leistungsbauelements bekannt, die mittels Stromquelle arbeiten.

Aus der US-A-5 939 909 ist eine Treiberschaltung für einen Leistungsfeldeffekttransistor bekannt. Dabei ist eine betragsmäßig kleinere Stromquelle ständig mit dem Gate des Leistungsfeldeffekttransistors verbunden, während eine größere Stromquelle je nach dem Zustand der Eingangsspannung zusätzlich auf das Gate aufgeschaltet wird.

### Vorteile der Erfindung

Die vorliegende Erfindung mit den Merkmalen des Hauptanspruchs hat demgegenüber den Vorteil, dass die elektromagnetische Verträglichkeit vergrößert, d.h. die elektromagnetische Abstrahlung von mit einer erfindungsgemäßen Vorrichtung angesteuerten elektrischen Leistungsbauelementen verringert wird. Dies ist insbesondere dann der Fall, wenn es sich um elektronische Schalter in getakteten Systemen handelt. Dadurch wird die Funktionssicherheit anderer elektrischer Komponenten und Systeme, die sich in räumlicher Nähe zu dem elektrischen Leistungsbauelement befinden, erheblich vergrößert.

Durch die in den abhängigen Ansprüchen aufgeführten Maßnahmen sind vorteilhafte Weiterbildungen und Verbesserungen der im Hauptanspruch angegebenen Vorrichtung möglich.

Insbesondere ist es von Vorteil, dass zwei Stromquellen vorgesehen sind, die über einen U/I-Konverter gesteuert wurden, wobei der U/I-Konverter eine Zeitsteuereinheit aufweist, wobei das Verhalten der Zeitsteuereinheit entweder über ein internes Zeitglied oder über eine Rückführung des Schaltausgangs bestimmt ist. Dadurch ist es sowohl möglich, durch Benutzung des internen Zeitgliedes eine reine Steuerung des Schaltausgangs des Leistungsbauelements vorzusehen, als auch möglich, durch Benutzung der Rückführung des Schaltausgangs eine Regelung vorzusehen.

Weiterhin ist von Vorteil, die erfindungsgemäße Vorrichtung monolithisch integriert vorzusehen. Hierdurch ist die Vorrichtung insbesondere kostenmäßig günstig herstellbar und weist darüberhinaus eine größere Funktionssicherheit auf.

### Zeichnung

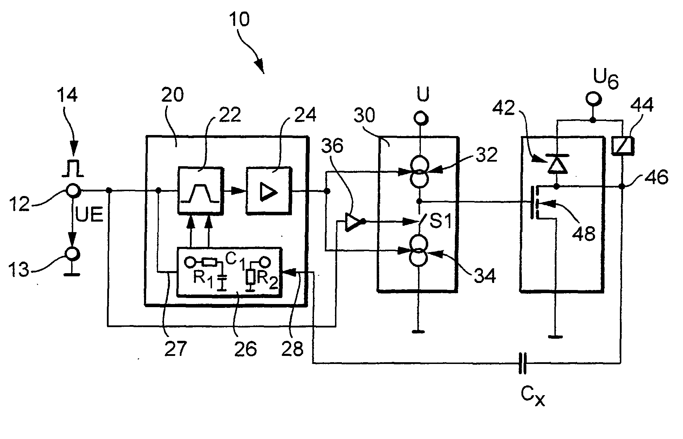

Ein Ausführungsbeispiel der Erfindung ist in der Zeichnung dargestellt und in der nachfolgenden Beschreibung näher erläutert. Es zeigt die einzige Figur ein Blockschaltbild der erfindungsgemäßen Vorrichtung zur Ansteuerung eines elektrischen Leistungsbauelementes.

### Beschreibung

In der einzigen Figur ist ein Blockschaltbild einer erfindungsgemäßen Vorrichtung 10 zur Ansteuerung dargestellt. die Vorrichtung 10 umfaßt einen ersten Schaltungsblock 20 und einen zweiten Schaltungsblock 30. Der erste Schaltungsblock weist einen Eingang 12 auf, der gegenüber einem mit dem Bezugszeichen 13 versehenen Grundpotential auf einem getakteten bzw. gepulsten Spannungsniveau liegt. Dieses Spannungsniveau ist in der Figur mit der Bezeichnung UE versehen. Die Tatsache, dass der Eingang 12 des ersten Schaltungsblocks 20 getaktet ist, wird durch einen mit dem Bezugszeichen 14 versehenen Taktimpuls in der Figur dargestellt.

Der erste Schaltungsblock 20 weist außer dem Eingang 12 einen Spannungs-Strom-Konverter bzw. U/I-Konverter 22 auf, der mit dem Eingang 12 verbunden ist. Weiterhin weist der erste Schaltungsblock 20 einen Verstärker 24 auf, dessen Eingang mit dem Ausgang des U/I-Konverters 22 verbunden ist. Weiterhin weist der erste Schaltungsblock 20 eine Zeitsteuereinheit 26 auf, die einen ersten Eingang 27 und einen zweiten Eingang 28 aufweist. Der erste Eingang 27 der Zeitsteuereinheit 26 ist mit dem Eingang 12 verbunden. Die Zeitsteuereinheit 26 weist weiterhin einen oder mehrere Ausgänge auf, die jeweils den U/I-Konverter steuern. Diese Ausgänge sind in der Figur durch zwischen der Zeitsteuereinheit 26 und dem U/I-Konverter 22 vorgesehene Pfeile dargestellt. Die Zeitsteuereinheit 26 weist ein internes Zeitglied, umfassend einen ersten Widerstand R1 und einen ersten Kondensator Cl zur Festlegung einer Zeitkonstante, auf. Darüberhinaus weist die Zeitsteuereinheit 26 einen zweiten Widerstand R2 auf, der mit einem später zu beschreibenden zweiten Kondensator Cx zusammenwirkt.

Der zweite Schaltungsblock 30 weist eine erste steuerbare Stromquelle 32 und eine zweite steuerbare Stromquelle 34 auf, die zwischen einer mit dem Bezugszeichen U versehenen Spannung und dem Grundpotential in Reihe geschaltet sind, wobei jedoch zwischen den Stromquellen 32, 34 ein steuerbarer Schalter S1 angeordnet ist, der die Reihenschaltung der Stromquellen 32, 34 unterbrechen kann. Hierbei ist die erste Stromquelle 32 zwischen dem Schalter S1 und der Spannung U vorgesehen und es ist die zweite Stromquelle 34 zwischen dem Schalter S1 und dem Grundpotential vorgesehen. Der Steuereingang beider steuerbarer Stromquellen 32, 34 ist zu deren Steuerung durch den ersten Schaltungsblock 20 jeweils mit dem Ausgang des Verstärkers 24 verbunden.

Der nicht mit einem Bezugszeichen bezeichnete Steuereingang des steuerbaren Schalters S1 ist im Beispiel über eine Vorrichtung 36 mit dem Eingang 12 verbunden. Bei der Vorrichtung 36 handelt es sich um einen Verstärker mit invertierendem Eingang. Wenn das Spannungsniveau UE auf "null" bzw. "low" liegt, ist der Schalter S1 geschlossen. Wenn das Spannungsniveau UE auf "high" liegt, ist der Schalter S1 geöffnet. Zwischen der ersten Stromquelle 32 und dem Schalter Sl ist erfindungsgemäß ein Abgriff vorgesehen, der mit dem Steuereingang eines elektrischen Leistungsbauelements 48, insbesondere eine D-MOS-Leistungsendstufe, verbunden ist. Das Leistungsbauelement 48 ist mit einem ersten seiner Leistungsanschlüsse - welcher im folgenden auch als Sourceanschluß bezeichnet wird - mit dem Grundpotential und mit einem zweiten seiner Leistungsanschlüsse - welcher mit dem Bezugszeichen 46 versehen und im folgenden auch als Drain bezeichnet ist - über eine Diode 42 mit einer mit dem Bezugszeichen U_{b} bezeichneten Versorgungsspannung verbunden. Zwischen dem zweiten Leistungsanschluss 46 und der Versorgungsspannung U_{b} ist parallel zu der Diode 42 eine Last 44 angeordnet. Der zweite Leistungsanschluss 46 wird im folgenden auch als Schaltausgang 46 des Leistungsbauelements 48 bezeichnet. Die Diode 42 ermöglicht im Falle einer induktiven Last 44 für die Zeit gleich nach dem Abschalten des Leistungsbauelements das Weiterfließen des zuvor eingeprägten Stroms auf den Anschluß der Versorgungsspannung U_{b} zurück solange der zuvor aufgeprägte Strom durch die induktive Last 44 noch fließt.

Der Schaltausgang 46 ist in einer vorteilhaften Ausführungsform der Erfindung über den zweiten Kondensator Cx mit dem zweiten Eingang 28 der Zeitsteuereinheit 26 verbunden.

Die erfindungsgemäße Vorrichtung zur Ansteuerung von Leistungsbauelementen, insbesondere Halbleiterbauelemente in Form von Leistungstransistoren mit spannungsgesteuerten Stromquellen, ermöglicht es, zusätzlich zur bekannten rampenförmigen Spannungssteuerung des Schaltausgangs 46 eine gleichzeitig einstellbare Stromsteuerung des Leistungsbauelement 48 unabhängig von der geschalteten Last durchzuführen. Der Lastsprung am Schaltausgang 46 des Leistungsbauelements 48 ist somit spannungs- und stromgesteuert bzw. spannungs- und stromgeregelt, wodurch sich eine minimale EMV-Belastung ergibt.

Die erfinungsgemäße Vorrichtung funktioniert derart, dass ein mit dem Taktimpuls 14 symbolisiertes Ansteuersignal der Spannung UE, d.h. ein Flankenwechsel, am Eingang 12 des ersten Schaltungsblocks 20 über den Schalter S1 die Lade- bzw. Entladsequenz der ersten Stromquelle 32 und der zweiten Stromquelle 34 einleitet. Die Ladesequenz wird mit UE im "high"-Zustand eingeleitet. Der Eingang des Leistungsschalters 48 bzw. des Leistungsbauelements 48 wird jetzt mit der ersten Stromquelle 32 beaufschlagt, somit eingeschaltet und die Last Last 44 nach dem Grundpotential bestromt. Wichtig ist hierbei, dass die erste Stromquelle 32 betragsmäßig kleiner als die zweite Stromquelle 34 ist. Ein Verhältnis kann jedoch erfindungsgemäß eingestellt werden. Die Entladesequenz wird mit UE auf "low"-Niveau eingeleitet. Weil die zweite Stromquelle 34 größer ist als die erste Stromquelle 32, wird der Bedarf der zweiten Stromquelle 34 sowohl aus der ersten Stromquelle 32 als auch aus dem Eingang des Leistungsschalters 48 bzw. des Leistungsbauelements 48 gedeckt. Das hat zur Folge, dass der Leistungsschalter 48 gesperrt wird und somit der Strom durch die Last 44 nicht mehr nach dem Grundpotential, sondern nach der Versorgungsspannung Ub fließt. Gleichzeitig mit der Lade-/Entladesequenz wird der U/I-Konverter 22 gestartet und steuert über den Verstärker 24 und die steuerbaren Stromquellen 32, 34 das Leistungsbauelement 48 in spannungsund stromgesteuerter bzw. spannungs- und stromgeregelter Weise an.

Die Zeitsteuerung des U/I-Konverters 22 mittels der Zeitsteuereinheit 26 kann erfindungsgemäß zum einen über das interne Zeitglied, welches den ersten Widerstand R1 und den ersten Kondensator C1 umfasst, durchgeführt werden. Hierdurch wird eine reine Steuerung des Schaltausgangs 46 bewirkt. Zum anderen kann die Zeitsteuerung erfindungsgemäß auch über den zweiten Widerstand R2 und den zweiten Kondensator Cx, d.h. über die Rückführung vom Schaltausgang 46 zur Zeitsteuerungseinheit 26, erfolgen, wodurch sich eine Regelung ergibt. Die Festlegung, welche der verschiedenen Möglichkeiten gewählt wird - möglich ist es auch, beide Möglichkeiten umschaltbar vorzusehen -, wird durch die gewählte Applikation oder durch die Stufe der Hochintegration definiert.

## Patentansprüche

1. Vorrichtung (10) zur Ansteuerung eines elektrischen Leistungsbauelements (48), wobei das Leistungsbauelement (48) einen Schaltausgang (46) aufweist, wobei bei einem Schaltvorgang am Leistungsbauelement (48) sowohl eine Spannungssteuerung oder eine Spannungsregelung als auch eine Stromsteuerung oder eine Stromregelung des Schaltausgangs (46) vorgesehen ist und der Steuereingang des Leistungsbauelements (48) durch zwei steuerbare Stromquellen (32, 34) gesteuert wird, und die Stromquellen (32,34) über einen U/I-Konverter (22) gesteuert werden, wobei der U/I-Konverter (22) eine Zeitsteuereinheit (26) aufweist **dadurch gekennzeichnet, dass** das Verhalten der Zeitsteuereinheit (26) umschaltbar, entweder über ein internes Zeitglied (R1, C1) oder über eine Rückführung (Cx) des Schaltausgangs (46) bestimmt und wobei das intern Zeitglied (R1, C1, R2) zwischen dem Eingang des U/I-Konverters (22) und Masse liegt und die Rückführung (Cx) vom Schaltausgang (46) auf den Widerstand (R2) der Zeitsteuereinheit (26) führt.

2. Vorrichtung (10) nach Anspruch 1, **dadurch gekennzeichnet, dass** das Leis - tungsbauelement (48) eine D-MOS-Leistungsendstufe ist.

3. Vorrichtung (10) nach einem der vorhergehenden Ansprüche, **dadurch gekennzeichnet, dass** die Vorrichtung monolithisch integriert vorgesehen ist.

## Claims

1. Device (10) for driving an electrical power component (48), wherein the power component (48) has a switching output (46), wherein, during a switching operation at the power component (48), there is an open-loop voltage control or a closed-loop voltage control and an open-loop current control or a closed-loop current control of the switching output (46) are provided and the control input of the power component (48) is controlled by two controllable current sources (32, 34), and the current sources (32, 34) are controlled via a U/I converter (22), wherein the U/I converter (22) has a timing control unit (26), **characterized in that** the behaviour of the timing control unit (26) is determined in switchable fashion, either via an internal timing element (R1, C1) or via a feedback (Cx) of the switching output (46), wherein the internal timing element (R1, C1, R2) is connected between the input of the U/I converter (22) and earth and the feedback (Cx) leads from the switching output (46) to the resistor (R2) of the timing control unit (26).

2. Device (10) according to Claim 1, **characterized in that** the power component (48) is a D-MOS power output stage.

3. Device (10) according to one of the preceding claims, **characterized in that** the device is provided in monolithically integrated fashion.

## Revendications

1. Dispositif (10) de commande d'un composant de puissance électrique (48), le composant de puissance (48) ayant une sortie de commutation (46),
lors d'une opération de commutation sur le composant de puissance (48) est prévue à la fois une commande en tension ou une régulation en tension et aussi une commande en intensité ou une régulation en intensité de la sortie de commutation (46) et l'entrée de commande du composant de puissance (48) est commandée par deux sources de courant (32, 34) et les sources de courant (32, 34) sont commandées par un convertisseur U/1 (22),
le convertisseur U/1 (22) ayant une unité de commande de temps (26),
**caractérisé en ce que**
le comportement de l'unité de temps (26) peut être commuté soit par un élément de temps (R1, C1) interne soit par une réaction (Cx) de la sortie de commutation (46), et
l'élément de temps (R1, C1, R2) interne, est monté entre l'entrée du convertisseur U/1 (22) et la masse, la réaction (Cx) de la sortie de commutation (46) est appliquée à la résistance (R2) de l'unité de commande de temps (26).

2. Dispositif (10) selon la revendication 1,
**caractérisé en ce que**
le composant de puissance (48) est un étage de puissance D/MOS.

3. Dispositif (10) selon l'une des revendications précédentes,
**caractérisé en ce que**
le dispositif est à intégration monolithique.
